# EUROPEAN PATENT APPLICATION

(11) **EP 2 645 431 A1**
(43) Date of publication of application: **02.10.2013**
(21) Application number: 12290109.3
(22) Date of filing: 28.03.2012
(51) Int. Cl.: H01L 31/18, H01L 31/0687, H01L 31/0304, C30B 33/06, H01L 21/18, H01L 21/20, H01L 21/762

(54) **Manufacture of multijuntion solar cell devices**

(71) Applicant: Soltec, 38190 Bernin (FR)
(72) Inventor: Ghyselen, Bruno, 38170 Seyssinet (FR); Arena, Chantal, 82505 Mesa AZ (US); Dimroth, Frank, Freiburg 79115 (DE); Grave, Matthias, 79115 Freiburg (DE)
(74) Representative: Grünecker, Kinkeldey, Stockmair & Schwanhäusser

(57) **Abstract**

The present invention relates to a method for manufacturing a multijunction solar cell device comprising the steps of providing a final base substrate; providing a first engineered substrate comprising a first zipper layer and a first seed layer; providing a second substrate; transferring the first seed layer to the final base substrate; forming at least one first solar cell layer on the first seed layer after transferring the first seed layer to the final base substrate thereby obtaining a first wafer structure; forming at least one second solar cell layer on the second substrate thereby obtaining a second wafer structure; and bonding the first and the second wafer structure to each other.

## Description

### Field of Invention

The present invention relates to the manufacture of multijunction solar cell substrates, in particular, to the manufacture of multijunction solar cell substrates comprising wafer transfer processes and the manufacture of solar cell devices for terrestrial and space-related applications.

### Background of the invention

Photovoltaic or solar cells are designed for converting the solar radiation to electrical current. In concentrator solar photovoltaic applications the incoming sun light is optically concentrated before it is directed to solar cells. For example, the incoming sun light is received by a primary mirror that reflects the received radiation toward a secondary mirror that, in turn, reflects the radiation toward a solar cell, which converts the concentrated radiation to electrical current by the generation of electron-hole pairs in III-V semiconductor or single crystal silicon, for example. Alternatively, the sunlight could be concentrated onto solar cells by using transmittive optics like Fresnel lenses.

Since different semiconductor material composition show optimal absorption for different wavelengths of the incoming solar light, multijunction solar cells have been proposed that comprise, for example, three cells showing optimal absorption in different wavelength ranges. A triple cell structure may comprise a GaInP top cell layer with a gap value of 1.8 eV, a GaAs intermediate cell layer with a gap value of 1.4 eV and a Ge bottom cell layer with a gap value of 0.7 eV, for instance. In principle, III-V or IV semiconductors can be used as active subcells of multijunction cell devices manufactured by layer transfer/bonding. Multijunction solar cells are usually manufactured by monolithic epitaxial growth. The monolithic growth process requires, in general, that any formed layers be substantially lattice matched to previously formed layers or the underlying substrate. However, the epitaxial growth of the solar cell layers on growth substrates still provides a demanding problem in view of lattice mismatches. For example, it is not suitable to epitaxially grow an InP solar cell layer on a Ge substrate, since the crystalline and optical characteristics of the InP solar cell layer would be heavily deteriorated due to crystal mismatch. In addition, in conventionally used transfer processes, intermediate substrates are lost after the transfer of epitaxially grown layers.

Thus, despite the recent engineering progress there is still a need for an improved manufacturing process for multijunction solar cell devices..

### Description of the Invention

The present invention addresses the above-mentioned need and, accordingly, provides a method for manufacturing a multijunction solar cell device, comprising the steps of
providing a final base substrate;
providing a second substrate;
transferring a first seed layer to the final base substrate;
forming at least one first solar cell layer on the first seed layer after transferring the first seed layer to the final base substrate thereby obtaining a first wafer structure;
forming at least one second solar cell layer on the second substrate thereby obtaining a second wafer structure; and
bonding the at least one second solar cell to the first wafer structure.

By the term "final" base substrate it is indicate that this base substrate will be the base substrate of the eventually completely manufactured multijunction solar cell.

The step of bonding the at least one second solar cell to the first wafer structure comprises bonding the at least one second solar cell layer to the at least one first solar cell layer A configuration with stacked solar cell layers can be obtained with a relatively small number of transfer steps thereby reducing the complexity of the manufacture of multijunction solar cells as compared to the manufacturing process of the art.

The term "engineered substrate" comprises a substrate that is different from a mere pure bulk substrate but rather includes a layer or interface that is formed in the substrate in order to facilitate its partial removal. In particular, the "engineered substrate" may comprise a zipper layer between a seed layer and a base substrate. In particular, the engineered substrate may comprise a base substrate that is detached from the seed layer in the step of removal of the engineered substrate.

Detachment by means of the zipper layer allows for recycling the detached substrate.

In the document, the expression "detachment of the engineered substrate" should be interpreted as the detachment of the base substrate. This detachment step may be followed by the removal of the possible residue of the zipper layer (if any), and of the removal of the seed layer from the remaining structure.

The zipper layer may be a weakened layer formed, e.g., by an appropriate treatment, for instance, a hydrogen or helium implantation in a substrate, that delimits an upper seed layer and a lower base substrate.

The zipper layer may be formed by a buried porous layer by anodic etching at a surface of the base substrate. Then epitaxial growth of the seed layer can be performed on top of the porous layer.

The zipper layer may be provided in form of an absorbing layer for laser lift-off, chemical lift off or mechanical splitting in an intermediate strained layer during an epitaxy sequence: SiGe in Si matrix, in particular, an intermediate strained layer of SiGe at 20% in a Si substrate. In this alternative, the zipper layer may be formed by the seed layer itself, for instance the seed layer can be selectively and chemically etched away to detach the engineered substrate.

The zipper layer may also be formed of a SiN absorbing layer for laser lift-off inserted between a seed layer and a transparent base substrate, as known for example from W02010015878.

Another possibility for an engineered substrate reads as follows A removable (presenting a low bonding energy of less than 1.5 J/m², and preferentially less than 1J/m²) bonding interface is formed between facing surfaces of a seed layer and a base support. In that possibility, the zipper layer is formed by the removable bonding interface. A first solar cell layer may be grown by epitaxy on the seed layer while preserving the removable character of the bonding interface, with the engineered substrate being heated to an epitaxial growth temperature. The low energy bonding is obtained by performing a treatment for augmenting the roughness of the facing surface of one of the seed layer or the substrate in particular carried out by chemical attack or etching, by effecting a treatment for decreasing hydrophilicity of the facing surface of one of the seed layer or the substrate (or the bonding layer in SiO₂ or Si₃N₄ on each of them). Moreover, a different material for the bonding layer can be chosen such that weak intrinsic mutual chemical affinity of the interface materials is achieved. The detachment of the base substrate may be performed by application of a thermal treatment or mechanical stresses applied from a jet of fluid or a blade, for example. This is disclosed for instance in WO03/063214.

As already mentioned, the engineered substrate includes a seed layer formed at the top of the zipper layer or removable bonding interface. The seed layer is transferred from the seed substrate to a base substrate by layer transfer from wafer to wafer, for example, by the Smart Cut^{™} process. The seed layer may contain or not an epitaxial layer that has been formed originally by epitaxy on the seed substrate. Alternatively, the seed layer has been transferred or detached from a bulk seed substrate. In a preferred embodiment of the present invention, the seed layer is not used as a solar cell layer but rather a first solar cell layer is grown on the seed layer.

The first seed layer may be exfoliated from an InP bulk substrate by H or He implants in some implantation layer. A part of the InP bulk substrate can then be detached after bonding to the final base substrate such that only a thin InP layer is formed on the final base substrate. A solar cell layer can be grown on the InP layer with high crystal and electrical quality. For example, a dislocation density of less than 10⁶ / cm² can be achieved.

The second substrate can be provided in form of an engineered substrate, in particular, comprising a sapphire base and a GaAs or Ge seed layer. After bonding to the at least one first solar cell layer formed on the final base substrate or on a handling substrate (as it will be described below), the bulk sapphire can be detached at a zipper layer.

Alternatively, the second substrate can be made of, or comprise, a massive material, like for instance GaAs or Ge. Grinding and/or etching of the second substrate may then be performed, after bonding, to obtain a free main surface of the at least one second solar cell layer.

According to a particular variant, in the above-described examples, the at least one first solar cell layer comprises two layers, a first and a second layer that has been formed, in particular, grown by epitaxy, on the first layer, and the at least one second solar cell layer also comprises two layers, namely a third and a fourth layer that has been formed, in particular, grown by epitaxy, on the third layer.

Preferably, in this variant, the method further comprises the step of
- attaching a handling substrate to the second wafer structure at the at least second solar cell layer;
- removing and in particular detaching the second substrate to obtain a third wafer structure
- bonding the third wafer structure to the first wafer structure

According to a particular example of this variant, the first solar cell layer comprises a first and a second layer and the second solar cell layer comprises a third and a fourth layer. In this case, the first layer (bottom cell) comprises or consists of GaInAs and/or the second layer comprises or consists of GaInAsP and/or the fourth layer (top cell in the finished multijunction solar cell device) comprises or consists of GaInP and/or the third layer comprises or consists of GaAs. Thus, a four-cell multijunction solar cell device is achieved wherein the material of each cell is optimized for a particular wavelength of the incoming solar light. By the use of the intermediate handling substrate, no inversion of layers is necessary during the entire manufacturing process according to this embodiment (i.e. the layer having a larger band gap is grown on top of the layer that has a smaller band gap).

As already mentioned, the at least one second solar cell layer is formed on the at least one first solar cell layer by direct bonding.

According to another variant, the first solar cell layer comprises a first and a second layer and the second solar cell layer comprises a fourth layer and a third layer. The sequence of enumeration of the third and fourth layers is reversed as compared to the previously described alternative. The third layer is formed on the fourth layer formed on the second substrate. Then, the third layer is bonded to the second layer formed on the first layer formed on the first seed layer. Thereby, inversion of layers (namely the third and fourth layers) during their formation on the second substrate is required (i.e. the layer having a smaller band gap is grown on top of the layer that has a wider band gap), but the integration process does not necessitate an intermediate handling substrate.

According to a particular example of this variant, the first layer (bottom cell) comprises or consists of GaInAs and/or the second layer comprises or consists of GaInAsP and/or the fourth layer (top cell in the finished multijunction solar cell device) comprises or consists of GaInP and/or the third layer comprises or consists of GaAs (see also detailed description below).

The present invention also provides a multijunction solar cell device, consisting of
a final base substrate made of Cu, Mo, W or Si or Al or AsGa;
a seed layer, in particular, an InP seed layer formed, in particular, bonded, on the final base substrate;
at least one first and at least one second solar cell layer formed on the seed layer.

In addition, it is provided a multijunction solar cell device obtainable by one of the above-described examples of the method for the manufacture of a multijunction solar cell device according to the present invention.

Additional features and advantages of the present invention will be described with reference to the drawings. In the description, reference is made to the accompanying figures that are meant to illustrate embodiments of the invention. It is understood that such embodiments does not represent the full scope of the invention.
Figure 1 illustrates an example for the inventive method for the manufacturing of a multijunction solar cell employing inversion of solar cell layers.
Figure 2 illustrates an example for the inventive method for the manufacturing of a multijunction solar cell without the inversion of solar cell layers.

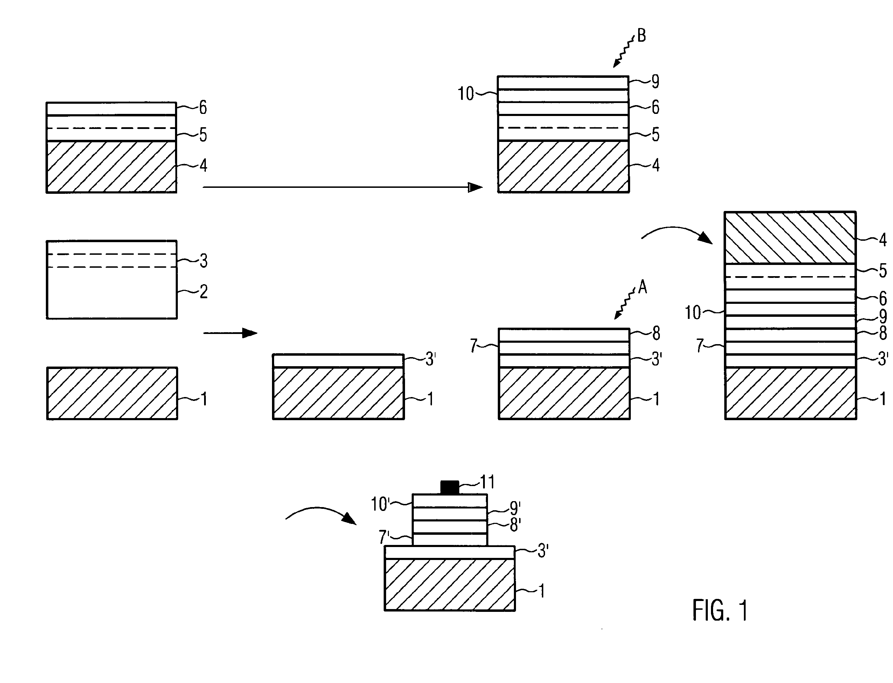

An example for the inventive method for the manufacturing of a multijunction solar cell comprising four solar cell layers is shown in Figure 1. A final base substrate 1 is provided. The final base substrate 1 may be made of Cu, Mo, W or Si or Al or AsGa. The final base substrate 1 will be the base substrate of the completed multijunction solar cell and provides mechanical stability during the processing, and preferably thermal, electrical conductivity during operation of the solar cell. A first substrate 2 comprising an implantation layer 3 (weakened layer) for later detachment of the first substrate 2 is provided. For example, the first substrate 2 is an InP bulk substrate. Implants for forming the implantation layer can comprise H and/or He.

The first substrate 2 is bonded to the final base substrate 1. After bonding the main part of the first substrate 2 is detached by means of the implantation layer 3 as it is known in the art. For example, the Smart Cut^{™} process may be employed. The detached bulk InP can be recycled. The thickness of the resulting InP layer 3' formed on the final base substrate 1 may be in the range of 50 nm to 1 µm. The free (upper) surface of the InP layer 3' may be prepared by polishing, etching, etc.

Alternatively, the seed layer can be formed on the final base substrate by bonding the first substrate on the final base substrate and reducing the thickness of the first substrate, for example, by grinding, etching.

Furthermore, it is provided an engineered substrate comprising a sapphire base 4, a zipper layer 5 and a GaAs or Ge (seed) layer 6. Sapphire may preferably be chosen in view of its coefficient of thermal expansion which is of importance for the temperature change (up and down) during epitaxy and for the further processing, in particular, bonding step (see below). Moreover, sapphire is transparent to laser light and can, thus, allow for laser lift-off in a later processing step (see below). The zipper layer 5 may be provided in form of an absorbing layer for laser lift-off.

Subsequently, a first 7 and second 8 solar cell layer are formed on the free surface of the InP layer 3' resulting in a first wafer structure A. Similarly, a fourth solar cell layer 10 and a third solar cell layer 9 are formed on the GaAs or Ge layer 6 of the engineered substrate resulting in a second wafer structure B.

The four solar cell layers 7 - 10 show absorption maxima for incident solar light for different wavelengths. The first solar cell layer 7 becomes the bottom cell and the fourth solar cell layer 10 becomes the top cell in the finished multijunction solar cell device. According to the present example all of the four monocrystal solar cell layers 7 - 10 are formed by epitaxial growth. In principle, the material of the solar cell layers can be selected form III-V semiconductors of the group consisting of InGaAs, GaAS, AlGaAs, InGaP, InP and InGaAsP. For example, the first solar cell layer 7 may be comprised of InGaAs, the second solar cell layer 8 may be comprised of InGaP, InGaAsP or InP, the third solar cell layer 9 may be comprised of GaAsP or GaAs, and the fourth solar cell layer 10 may be comprised of InGaP or InAlAs. Appropriate tunnel junction layers may be provided between particular ones of the solar cell layers by deposition or growth on a respective solar cell layer.

In the next step illustrated in Figure 1 the first wafer structure A and the second wafer structure B are bonded to each other. In case of direct bonding, which forms the preferred embodiment according to the invention, the polishing of the surface of the solar cell layers to be bonded may be performed in order to smooth the surface, better than to 0.5 nm RMS over a field of 5x5 micrometers for example to obtain a enhanced bonding strength between the solar cell layers and improved efficiency and reliability of the subsequent solar cell. Alternatively, an electrically conductive, optically transparent material can be used as a bonding layer and facilitates the adhesion of the two structures. In any case, the bonding interface is between the second solar cell layer 8 and the third solar cell layer 9. The sapphire base 4 of the second engineered substrate is then detached by means of the zipper layer 5 and the GaAs or Ge layer 6 is removed, for instance by etching, thereby resulting in a free upper main surface of the fourth solar cell layer 10. Detachment by means of the zipper layer allows for recycling the detached sapphire base 4.

It should be noted that relatively high temperatures may be involved in the step of bonding the first wafer structure A and the second wafer structure B to each other. Contacting and bonding can be performed at relatively high temperatures of about 400 °C to 600 °C and more preferably between 450 °C and 550 °C. Preferably, the contacting step is performed at room temperature followed by an annealing step reaching max temperature between 400° and 600°C, although it is not excluded to perform the contacting step at a higher temperature. This bonding step is crucial for the quality of the resulting multijunction solar cell and it is favourable to perform high-temperature bonding anneal in order to achieve a high-quality bonding interface between the lower surface of the second substrate and the second solar cell layer 5 without significant defects.

The material for the final base substrate 1 may be chosen according to the coefficient of thermal expansion of the various materials involved during bonding. It is Mo that may preferably be chosen in this respect, in particular if the engineered substrate comprising a sapphire base.

The resulting structure is subject to some finish processing comprising the formation of a plurality of mesas comprising etched solar cell layers 7', 8', 9' and 10'. The formation of the mesas can be achieved by lithographic processing after the formation of an appropriately patterned photoresist and optionally formed anti-reflective coating. An electrical contact 11 is formed on the patterned fourth solar cell layer 10'.

It should be noted that instead of the engineered substrate, a GaAs or Ge bulk substrate can be used as the second substrate. The second substrate is then removed by etching/grinding after bonding of the first wafer structure A.

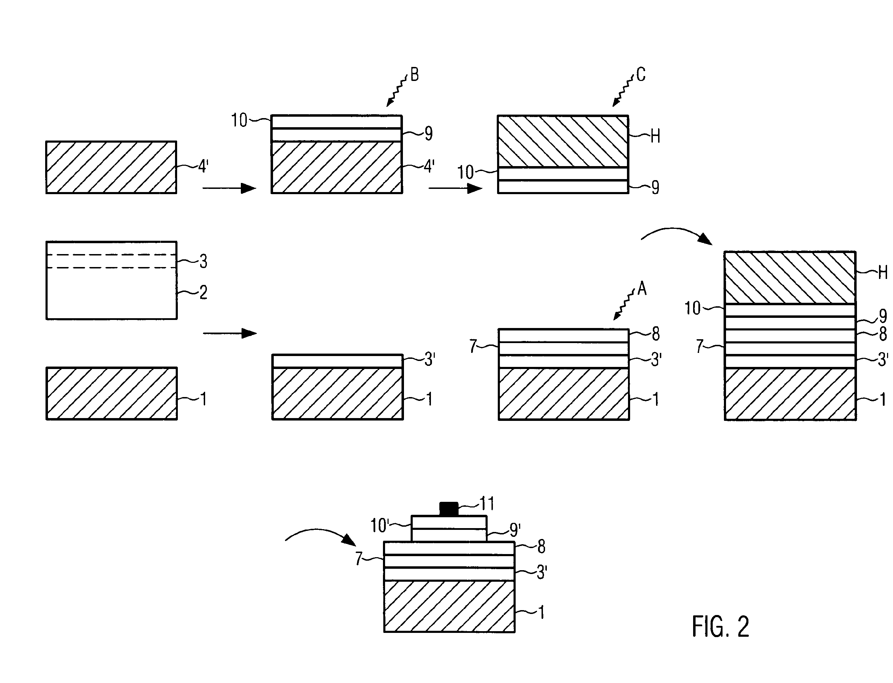

Figure 2 illustrates another example for the herein disclosed method. According to the example shown in Figure 1 inversion of third and fourth solar cell layers 9 and 10 on the second substrate is necessary. Contrary, in the example illustrated in Figure 2 no such inversion is included in the manufacturing process.

As in the example of Figure 1 a final base substrate 1 is provided. The final base substrate 1 may be made of Cu, Mo, W or Si or Al. A first substrate 2 comprising an implantation layer (weakened layer) 3 for later detachment of the first substrate 2 is provided. For example, the first substrate 2 is an InP bulk substrate comprising a weakened layer 3. A second substrate 4' is provided in form of a GaAs or Ge bulk substrate. A thin InP 3' is transferred from the first substrate 2 to the final base substrate 1 as it is described in the example shown in Figure 1. Moreover, a first 7 and a second 8 solar cell layer are formed on the InP layer 3' resulting in a first wafer structure A. Similarly, a third 9 and a fourth 10 solar cell layer are formed on the GaAs or Ge bulk substrate 4'. For the first 7 to fourth 10 solar cell layers the same materials can be chosen as in the example illustrated in Figure 1

Then, a handling substrate H is attached by means of an adhesive layer to the **4^{th}** solar cell layer. The handling substrate can be a glass substrate, and the adhesive can be a glue layer. Then the second substrate 4' can be removed to form the structure C. In the case the second substrate is an engineered substrate, it can be detached.

Bonding of the first and second wafer structures A and C results in the configuration shown on the right-hand side of the upper row of Figure 2. Contacting and bonding can be performed as described in the previous example. The handling wafer H is removed after bonding.

The resulting structure is subject to some finish processing comprising the formation of a plurality of mesas comprising etched solar cell layers 9' and 10'. The formation of the mesas can be achieved by lithographic processing after the formation of an appropriately patterned photoresist and optionally formed anti-reflective coating. An electrical contact 11 is formed on the patterned fourth solar cell layer 10'.

All previously discussed embodiments are not intended as limitations but serve as examples illustrating features and advantages of the invention. It has to be understood that some or all of the above described features can also be combined in different ways. In particular, it is possible according to the invention to form mutli-junction solar cells not only composed of 4 junctions (as generally disclosed in the previous embodiments) but also 2, 3, 5 or more.

## Claims

1. Method for manufacturing a multijunction solar cell device comprising the steps of
providing a final base substrate;
providing a second substrate;
transferring a first seed layer to the final base substrate;
forming at least one first solar cell layer on the first seed layer after transferring the first seed layer to the final base substrate thereby obtaining a first wafer structure;
forming at least one second solar cell layer on the second substrate thereby obtaining a second wafer structure; and
bonding the at least one second solar cell to the first wafer structure.

2. The method according to claim 1, where the step of bonding the first and the second wafer structure to each other comprises bonding the second substrate whereupon the at least one second solar cell layer is formed to the at least one first solar cell layer.

3. The method according to claim 1, wherein the step of bonding the first and the second wafer structure to each other comprises directly bonding the at least one second solar cell layer to the at least one first solar cell layer.

4. The method according to one of the preceding claims, wherein the step of transferring the first seed layer to the final base substrate comprises the step of bonding a first substrate to the final base substrate and detaching a part of the first substrate at an implantation layer.

5. The method according to one of the preceding claims, further comprising forming a second seed layer on the second substrate and subsequently forming the at least one second solar cell layer on the second seed layer.

6. The method according to one of the preceding claims, further comprising bonding the second wafer structure to a handling substrate, removing the second substrate, and wherein the step of bonding the second solar cell to the first wafer structure comprises bonding the handling substrate whereupon the at least second solar cell layer is formed onto the at least one solar cell layer.

7. The method according to one of the preceding claims, wherein the second substrate is a bulk substrate, in particular, a GaAS or Ge bulk substrate, or an engineered substrate, in particular, an engineered substrate comprising a zipper layer, a sapphire base and a GaAs or Ge seed layer whereupon the at least one second solar cell layer is to be formed.

8. The method according to claim 7, further comprising detaching the sapphire base of the second engineered substrate after bonding the first and the second wafer structure to each other.

9. The method according to one of the preceding claims, wherein the at least one first solar cell layer comprises a first and a second layer on the first layer and/or the at least one second solar cell layer comprises a third and a fourth layer on the third layer.

10. The method according claim 2, wherein the at least one first solar cell layer comprises a first and a second layer on the first layer and/or the at least one second solar cell layer comprises a third and a fourth layer on the third layer and wherein the first layer comprises or consists of GaInAs and/or the second layer comprises or consists of GaInAsP and/or the third layer comprises or consists of GaAs and/or the fourth layer comprises or consists of GaInP.

11. The method according claim 3, wherein the at least one first solar cell layer comprises a first and a second layer on the first layer and/or the at least one second solar cell layer comprises a fourth and a third layer on the fourth layer and wherein the first layer comprises or consists of GaInAs and/or the second layer comprises or consists of GaInAsP and/or the third layer comprises or consists of GaAs and/or the fourth layer comprises or consists of GaInP.

12. The method according one of the preceding claims, wherein the final base substrate made of Cu, Mo, W or Si or Al or AsGa.

13. The method according to one of the preceding claims, further comprising
forming mesas of the at least one first and the at least one second solar cell layers;
and forming a contact on the free main surface of the at least one second solar cell layer.

14. Multijunction solar cell device obtainable by the method according to one of the preceding claims.

15. Multijunction solar cell, consisting of
a final base substrate made of Cu, Mo, W or Si or Al or AsGa;
a seed layer, in particular, an InP seed layer formed, in particular, bonded, on the final base substrate; and
at least one first and at least one second solar cell layer formed on the seed layer.

16. The multifunction solar cell of claim 15, wherein the at least second solar cell is bonded onto the at least first solar cell.
